# FASCICULE DE BREVET EUROPEEN

(11) **EP 3 631 843 B1**
(45) Date de publication et mention de la délivrance du brevet: **17.03.2021**
(21) Numéro de dépôt: 18724929.7
(22) Date de dépôt: 24.05.2018
(51) Int. Cl.: H01L 21/3063, B81C 1/00

(54) **PROCÉDÉ DE RÉALISATION DE MOTIFS DANS UN SUBSTRAT**
VERFAHREN ZUR HERSTELLUNG VON MUSTERN AUF EINEM SUBSTRAT
METHOD FOR PRODUCING PATTERNS IN A SUBSTRATE

(30) Priorité: 24.05.2017 FR 1754648
(43) Date de publication de la demande: 08.04.2020
(73) Titulaire: Commissariat à l'Énergie Atomique et aux Énergies Alternatives, 75015 Paris (FR)
(72) Inventeur: NOURI, Lamia, 38100 Grenoble (FR); GAILLARD, Fr d ric-Xavier, 38500 Voiron (FR); LANDIS, Stefan, 38210 Tullins (FR); POSSEME, Nicolas, 38360 Sassenage (FR)
(74) Mandataire: Hautier, Nicolas
(86) Numéro de dépôt international: PCT/EP2018/063742
(87) Numéro de publication internationale: WO 2018/215635

(56) Documents cités:
- WO-A1-2016/102609
- US-B1- 6 617 191
- US-B1- 6 790 340
- EE JIN TEO ET AL: "Fabrication of silicon microstructures using a high-energy ion beam", PROCEEDINGS OF THE SPIE - THE INTERNATIONAL SOCIETY FOR OPTICAL ENGINEERING SPIE-INT. SOC. OPT. ENG. USA, vol. 5347, no. 1, 2004, pages 264-270, XP002783440, ISSN: 0277-786X
- JAKUBOWICZ ET AL: "Nanoporous silicon fabricated at different illumination and electrochemical conditions", SUPERLATTICES AND MICROSTRUCTURES, ACADEMIC PRESS, LONDON, GB, vol. 41, no. 4, 1 avril 2007 (2007-04-01), pages 205-215, XP022090546, ISSN: 0749-6036, DOI: 10.1016/J.SPMI.2006.12.003
- MENZEL F ET AL: "Fabrication of microstructures in III-V semiconductors by proton beam writing", NUCLEAR INSTRUMENTS & METHODS IN PHYSICS RESEARCH. SECTION B: BEAM INTERACTIONS WITH MATERIALS AND ATOMS, ELSEVIER BV, NL, vol. 267, no. 12-13, 15 juin 2009 (2009-06-15), pages 2321-2326, XP026157217, ISSN: 0168-583X, DOI: 10.1016/J.NIMB.2009.03.023 [extrait le 2009-03-12]

## Description

### DOMAINE TECHNIQUE DE L'INVENTION

L'invention concerne en général les procédés micro-électroniques de réalisation sur la face avant d'un substrat de motifs bidimensionnelles (2D) ou tridimensionnelles (3D) possiblement complexes.

Elle trouve pour applications particulièrement avantageuses mais non limitatives la structuration de la surface d'un substrat pour la réalisation de dispositifs microélectroniques, électroniques, micromécaniques, électromécaniques (MEMS, NEMS...), microfluidiques, optiques ou optoélectroniques.

### ÉTAT DE LA TECHNIQUE

Il existe de nombreuses solutions pour obtenir des motifs bidimensionnelles (2D) ou tridimensionnelles (3D) sur la face avant d'un substrat. Toutes les solutions connues présentes des limitations ou des inconvénients.

La solution la plus classique pour structurer la face avant d'un substrat en formant des motifs, en particulier en deux dimensions consiste à réaliser, par exemple par lithographie, un motif préalable dans une couche de masquage surmontant un substrat, puis à effectuer une gravure humide du substrat à travers la couche de masquage. L'inconvénient de cette solution provient essentiellement du caractère isotrope de la gravure humide ce qui conduit à un faible contrôle dimensionnel.

D'autres solutions, plus récentes, consistent à effectuer des gravures par plasma. Les équipements de plasma à couplage inductif (ICP) ont permis d'améliorer significativement l'anisotropie de la gravure et la sélectivité de gravure pour certains matériaux. Néanmoins, les ions du plasma, du fait de leur énergie importante (rarement moins qu'une quinzaine d'eV), pénètrent bien souvent à une profondeur plus importante que celle que l'on souhaite graver. Par ailleurs, il est souvent très délicat de contrôler avec précision la nature des espèces implantées. En effet, le bombardement ionique arrache des atomes à l'ensemble des couches soumises au plasma et ces atomes arrachés peuvent pénétrer dans la couche à graver ou dans les couches sous-jacentes au substrat lorsque ce dernier est mince. Cela peut provoquer une contamination du substrat ou des couches sous-jacentes au substrat.

Par ailleurs, il s'avère que lors de la gravure plasma des charges s'accumulent en haut et bas des motifs. Ces charges dévient les trajectoires des ions et détériorent au final le contrôle dimensionnel des motifs ainsi que la verticalité des flancs.

D'autres types de plasma ont été proposés pour limiter les inconvénients mentionnés ci-dessus. En particulier, les plasmas pulsés ont été développés pour minimiser l'endommagement des couches sous-jacentes lorsque le substrat est très mince. Cependant, les plasmas pulsés ne permettent pas de supprimer totalement cette détérioration. Par ailleurs, les vitesses de gravure de ces plasmas pulsés sont faibles ce qui rend leur industrialisation problématique ou limitées à certaines applications seulement.

Une autre solution en cours de développement consiste à effectuer une gravure par couche atomique (ALE pour atomic layer etching). Ce type de gravure consiste à modifier une première couche atomique d'un matériau au cours d'une étape auto-limitante, puis à retirer cette couche au cours d'une deuxième étape, sans endommager le matériau sous-jacent. Le processus est répété de manière cyclique pour atteindre l'épaisseur souhaitée. Ainsi, la gravure par couche atomique présente pour avantage de réduire l'endommagement des couches sous-jacentes au substrat que l'on souhaite graver. En revanche, cette solution présente pour inconvénient majeur que la vitesse de gravure obtenue est trop faible pour une application industrielle.

Le document US 6 617 191 prévoit d'implanter une zone d'un substrat puis de la recouvrir d'une multitude de couches pour former un empilement. L'empilement est ensuite plongé dans une solution aqueuse pour retirer la zone implantée.

La publication « Fabrication of Silicon microstructures using a high-energy ion beam », dont les auteurs sont Ee Jin Teo et al., parue dans Proceedings of SPIE Vol. 5347 (SPIE, Bellingham, WA, 2004) doi: 10.1117/12.524314, prévoit d'irradier des zones d'un substrat à l'aide d'un faisceau de protons rapides ou d'hélium. Les zones non irradiées sont ensuite retirées et les zones irradiées sont conservées.

Un objet de la présente invention est donc de proposer une solution pour limiter, voire éviter, les inconvénients d'au moins certaines des solutions connues pour structurer en épaisseur la face avant d'un substrat.

En particulier, un objectif de la présente invention est de proposer une solution pour structurer la face avant d'un substrat en réalisant des motifs aux formes relativement libres et complexes, avec un contrôle dimensionnel acceptable et une vitesse de gravure compatible avec des contraintes industrielles.

Un autre objectif de la présente invention et de proposer une solution pour réaliser sur la face avant d'un substrat une structuration formée de motifs dont le matériau présente les mêmes propriétés que les propriétés initiales du substrat, c'est-à-dire les propriétés que présentait le substrat en début de procédé.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Pour atteindre cet objectif, selon la présente invention prévoit un procédé selon la revendication 1.

Ainsi, dans le procédé selon l'invention, l'implantation crée localement des défauts dans le matériau du substrat dans le but de réduire sa résistivité. Cela permet de faciliter le mouvement des porteurs de charge durant la porosification. Ainsi, la porosification s'effectue uniquement dans les zones implantées. Tout au moins, la porosification s'effectue de manière plus rapide dans les zones implantées que dans les zones non d'implantées.

Ainsi, à l'issue de l'étape de retrait, la face avant du substrat se trouve gravée au niveau de l'au moins une première zone. Les motifs de masquage préalablement définis dans la couche de masquage sont donc transférés dans le substrat.

Le procédé selon l'invention permet d'obtenir une structuration de la face avant d'un substrat avec un très bon contrôle dimensionnel. Par ailleurs, la paroi des motifs est définie par la ou les directions choisie(s) pour l'implantation. La géométrie des flancs des motifs est donc contrôlée avec précision. En particulier, le procédé selon l'invention permet d'obtenir des flancs verticaux de manière aisée et reproductible.

En outre, dans le procédé revendiqué, la nature des ions qui pénètrent dans le substrat lors de l'implantation est parfaitement maîtrisée. Ainsi, si certains des ions pénètrent dans une couche sous-jacente au substrat que l'on souhaite graver, la nature de ces ions implantés involontairement sera parfaitement maîtrisée. Il sera ainsi avantageux d'implanter des ions neutres afin d'éviter une contamination de la couche sous-jacente. Au contraire, dans les procédés de gravure plasma, il est très délicat de maîtriser avec précision la nature des ions qui pénètrent effectivement dans le substrat que l'on souhaite graver et la couche qui lui est sous-jacente. Il en résulte un endommagement voire une contamination de la couche sous-jacente.

Par ailleurs, les ions implantés lors de l'étape d'implantation ont pour but de modifier la résistivité du substrat. Ils n'ont pas pour but de pulvériser le substrat. Par conséquent, l'énergie des ions qui parviennent sur le substrat est limitée. Ainsi, par rapport aux gravures plasma, l'invention présente pour avantage d'éviter l'endommagement des couches sous-jacentes du substrat.

En outre, l'étape de retrait par gravure électrochimique prévue dans l'invention s'effectue à une vitesse parfaitement compatible avec les contraintes industrielles. Par exemple, le procédé selon l'invention permet de graver entre 100 et 200 nanomètres de silicium en 30 secondes, ce qui permet une productivité très largement supérieure à celle d'un procédé de gravure par couche atomique (ALE).

Par ailleurs, le procédé selon l'invention présente pour avantage d'être stable et aisément reproductible.

De manière particulièrement avantageuse à l'issue du procédé, les motifs obtenus sont formés par des zones du substrat qui n'ont pas été implantées ou qui ont été peu implantées. Les motifs obtenus présentent donc les propriétés que le matériau du substrat présente avant implantation. En particulier, si le substrat est fait d'un matériau semi-conducteur, les motifs formés dans le substrat présenteront les mêmes propriétés semi-conductrices. Typiquement les motifs finaux seront en silicium intrinsèque si le substrat de départ est également en silicium intrinsèque

Le procédé selon la présente invention trouve pour applications particulièrement avantageuses mais non limitatives la structuration en épaisseur de la face avant d'un substrat pour la réalisation de dispositifs microélectroniques, électroniques, micromécaniques, électromécaniques (MEMS, NEMS...), microfluidiques, optiques ou optoélectroniques.

### BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
La FIGURE 1 composée des figures 1a à 1f, illustre des étapes d'un mode de réalisation de la présente invention.
Les FIGURES 2a et 2b illustrent chacune une étape d'électrochimie selon deux modes de réalisation alternatifs, au cours de laquelle le substrat à graver est plongé dans un électrolyte.
La FIGURE 3 composée des figures 3a à 3d, illustre de manière simplifiée des étapes de porosification d'une couche de silicium.
La FIGURE 4 est un graphe illustrant les régimes de porosification et d'électro polissage pour un substrat en silicium de type P.
La FIGURE 5 composée des figures 5a à 5d, illustre des étapes d'un autre mode de réalisation de la présente invention, dans lequel on forme dans la couche de masquage des motifs en trois dimensions par nano-impression.
La FIGURE 6 composée des figures 6a à 6d, illustre des étapes d'un autre mode de réalisation de la présente invention, dans lequel on forme dans la couche de masquage des motifs en deux dimensions.
La FIGURE 7 composée des figures 7a à 7c, illustre des étapes d'un autre mode de réalisation de la présente invention, dans lequel on prévoit une couche tampon entre le substrat et la couche de masquage.
La FIGURE 8 composée des figures 8a à 8d, illustre des étapes d'un autre mode de réalisation de la présente invention, dans lequel on forme un profil en marche d'escalier.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et des motifs ne sont pas représentatives de la réalité.

### DESCRIPTION DÉTAILLÉE DE L'INVENTION

Dans le cadre de la présente demande, on considère qu'une couche, par exemple formant un substrat, est poreuse lorsque la présence de vide dans la couche est supérieure à 5% et de préférence comprise entre 5 et 50% et de préférence comprise entre 5 et 10%.

Dans le cadre de la présente invention, on désigne par motif en trois dimensions un motif présentant un profil présentant au moins deux niveaux discrets de hauteur ou qui présente un profil analogique avec une variation continue des tangentes de la forme du profil.

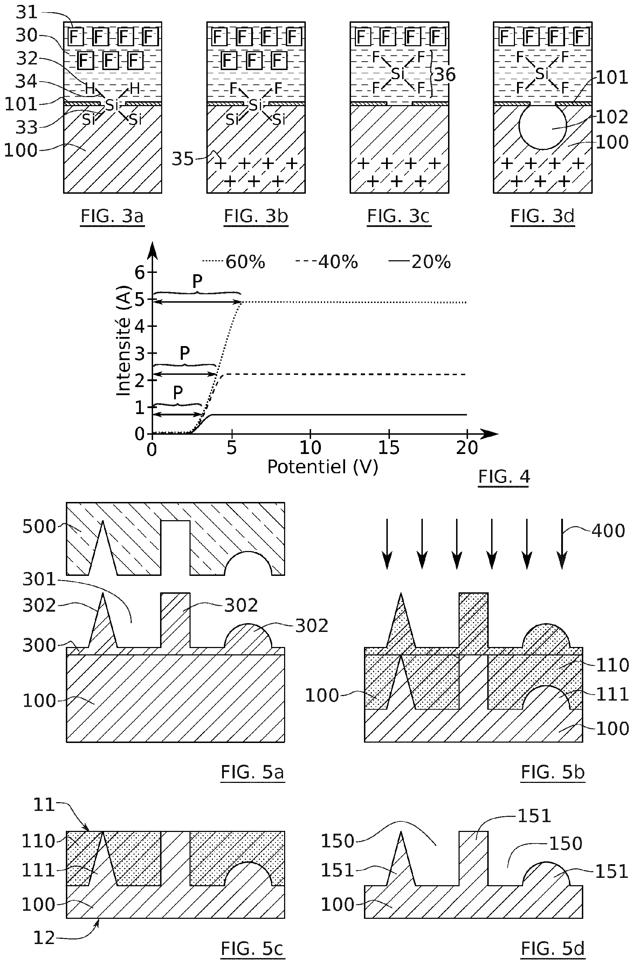

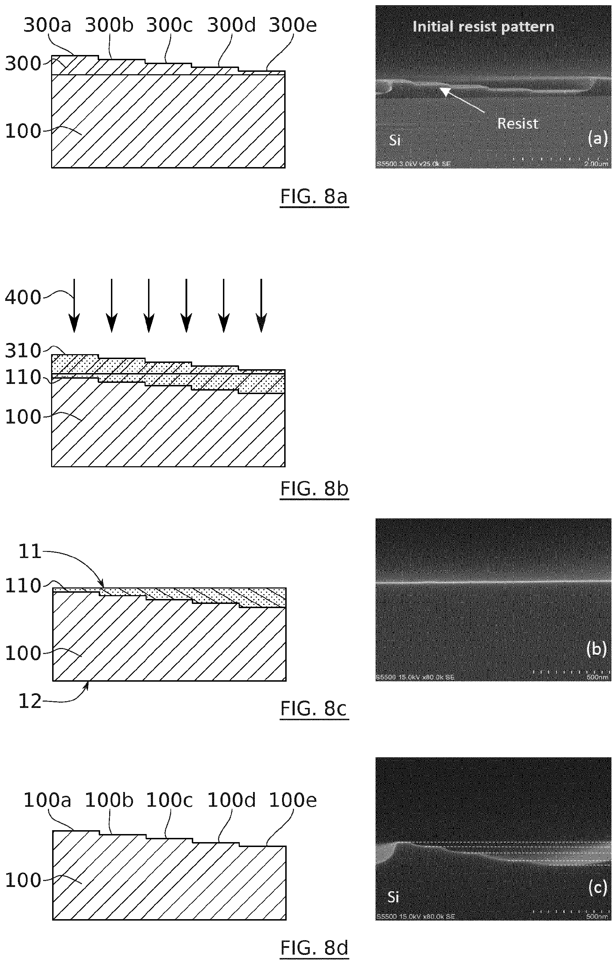

Ainsi, un motif en 3D présente dans une couche donnée, par exemple une résine ou un substrat, au moins deux niveaux de profondeur au-dessous de la face supérieure de la couche lorsque le motif est en creux ou au moins deux niveaux de hauteur au-dessus d'une face supérieure de la couche lorsque le motif est en saillie. Cela apparaît clairement sur les figures 5a à 5d et 8a à 8d par exemple qui seront décrites en détail par la suite.

Dans le cadre de la présente invention, on qualifie de résine un matériau organique ou organo-minéral pouvant être mis en forme par une exposition à un faisceau d'électrons, de photons ou de rayons X ou mécaniquement.

Il est précisé que, dans le cadre de la présente invention, l'épaisseur d'une couche ou du substrat se mesure selon une direction perpendiculaire à la surface selon laquelle cette couche ou ce substrat présente son extension maximale. Sur les figures, le substrat forme une plaque s'étendant principalement dans un plan horizontal et l'épaisseur est prise selon la verticale.

De même lorsqu'on indique qu'un élément est situé au droit d'un autre élément, cela signifie que ces deux éléments sont situés tous deux sur une même ligne perpendiculaire au plan principal du substrat, soit sur une même ligne orientée verticalement sur les figures

Il est précisé que, dans le cadre de la présente invention, les termes « sur », « surmonte », « recouvre », « sous-jacent » et leurs équivalents ne signifient pas forcément « au contact de ». Ainsi par exemple, le report, le collage, l'assemblage, l'application ou le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

L'emploi du singulier pour certains éléments de l'invention ne signifie pas obligatoirement qu'un élément donné est présent de manière unique dans l'invention. Le mot « un » ou « une » ne signifie donc pas exclusivement respectivement « un seul » ou « une seule » à moins qu'il en soit disposé autrement.

On entend par un substrat ou un film ou une couche, « à base » d'un matériau A, un substrat, un film, une couche comprenant ce matériau A et éventuellement d'autres matériaux, par exemple des éléments dopants.

Avant d'entamer une revue détaillée de modes de réalisation de l'invention, sont énoncées ci-après des caractéristiques optionnelles qui peuvent éventuellement être utilisées en association ou alternativement :
Selon un mode de réalisation, l'implantation est réalisée de manière à ce que p2 ≥ 1.1*p1, de préférence de manière à ce que p2 ≥2*p1, de préférence de manière à ce que p2 ≥ 3*p1
Par exemple, les résistivités p1 et p2 seront déterminées par la méthode SSRM, acronyme de Scanning Spreading Résistance Microscopy, bien connue de l'homme du métier.

Selon un mode de réalisation, l'électrochimie est réalisée de manière à créer une porosification de l'au moins une première zone.

Selon un mode de réalisation, l'électrochimie est réalisée de manière à ce que ladite porosification des zones modifiées entraîne leur consommation durant le procédé.

Ainsi, l'avantage de ce mode de réalisation est que l'étape d'électrochimie, du fait de la porosification, suffit à retirer les zones modifiées sélectivement aux zones non modifiées. Le substrat retiré de l'électrolyte présente ainsi les motifs finaux.

L'avantage de ce mode de réalisation et que l'implantation peut être faite avec tous les types d'ions. On privilégiera en particulier les ions neutres tels que les ions argon.

Selon un autre mode de réalisation, l'électrochimie est réalisée de manière à ce que ladite porosification des zones modifiées n'entraîne pas la consommation de l'au moins une première zone par rapport à l'au moins une deuxième zone et l'étape de retrait comprend également, après l'étape électrochimie, une étape de gravure de l'au moins une première zone rendue poreuse sélectivement à l'au moins une deuxième zone.

Selon un mode de réalisation, les ions implantés lors de l'implantation sont des ions dont la masse atomique est supérieure ou égale à celle du bore. Ce mode de réalisation a pour avantage qu'avec ce type de masse atomique, le détachement de la partie implantée s'effectue de manière très facile voire systématique. Typiquement lorsqu'il n'y a pas de couche tampon apte à empêcher la formation d'une couche carbonée en surface du substrat, des doses supérieures à 1.E21 atomes/cm³, permettent d'obtenir un détachement de la couche implantée. Lorsqu'il y a une couche tampon, des doses supérieures à 1.E19 atomes/cm³ permettent d'obtenir un détachement aisé voire systématique de la couche implantée.

Les ions implantés sont par exemple pris parmi les ions suivants : bore ou argon.

Selon un mode de réalisation, les ions implantés lors de l'implantation sont pris parmi les ions à base d'hydrogène (H) et les ions à base d'hélium (He).

Selon un mode de réalisation, l'implantation ionique du substrat est réalisée de manière à ce que les ions soient implantés avec une énergie inférieure ou égale à 150keV.

Notamment lorsque les ions implantés sont des ions hydrogène ou hélium, cela permet de réduire efficacement la résistivité du substrat.

Selon un mode de réalisation, l'étape de retrait comprend une gravure humide sélective de l'au moins une première zone rendue poreuse sélectivement à l'au moins une deuxième zone.

Selon un mode de réalisation, la gravure humide est réalisée en milieu alcalin avec par exemple de l'hydroxyde de potassium (KOH) ou de l'hydroxyde de tetramethylammonium (TMAH).

Cette étape peut être effectuée en combinaison avec chacun des modes de réalisation de l'invention. Elle permet de retirer toute la zone modifiée si cette dernière reste entièrement solidaire du substrat après avoir été rendue poreuse. Cette étape peut également permettre de retirer d'éventuelles portions résiduelles de zones poreuses qui ne seraient pas détachées alors qu'une partie des zones poreuses s'est détachée du substrat.

Selon un autre mode de réalisation combinant les deux précédents, ladite implantation ionique du substrat est réalisée de manière à former plusieurs premières zones modifiées par implantation, et l'électrochimie est réalisée de manière à ce que ladite porosification des zones modifiées:
- entraîne un détachement complet de certaines seulement parmi les premières zones, par rapport à l'au moins une deuxième zone,
- n'entraîne pas un détachement complet des autres premières zones par rapport à l'au moins une deuxième zone et l'étape de retrait comprend également, après l'étape électrochimie, une étape de gravure desdites autres premières zones.
Ainsi, l'électrochimie est réalisée de manière à ce que certaines zones modifiées se détachent d'elles-mêmes. On applique par ailleurs une étape de gravure, identique à celle mentionnée précédemment, pour retirer lesdites autres zones modifiées qui ne se sont pas détachées d'elles-mêmes.

Selon un mode de réalisation, l'étape de retrait comprend une illumination de la face arrière du substrat de manière à ce que la face arrière du substrat présente des porteurs de charges lors de l'étape d'électrochimie.

Selon un mode de réalisation, l'illumination est effectuée pendant l'étape d'électrochimie.

Selon un mode de réalisation, alternatif ou combiné avec le mode de réalisation comprenant une illumination, le procédé comprend, avant l'étape de plongée substrat dans l'électrolyte, une étape de dopage (typiquement un dopage p+) de la face arrière de manière à ce que la face arrière du substrat présente des porteurs de charges lors de l'étape d'électrochimie.

Selon un mode de réalisation, la couche de masquage est une couche de résine, et l'étape de définition d'au moins un motif de masque dans la couche de masquage comprend au moins l'un parmi : une lithographie optique, une lithographie électronique, une lithographie par nano-impression, un procédé d'auto-assemblage direct (DSA acronyme de « Direct Self Assembled »).

Lors de l'étape d'implantation, le substrat est surmonté d'une couche tampon située entre la face avant du substrat et la couche de masquage.

La couche de masquage comprend des atomes de carbone. Il s'agit ainsi d'une couche carbonée, comme par exemple une couche de résine. La couche tampon est conformée, en particulier son épaisseur et sa matière, de manière à piéger les atomes de carbone qui seraient arrachés à la couche de masquage lors de l'implantation ionique. Ainsi, ces atomes de carbone arrachés se trouvent piégés dans la couche tampon et ne pénètrent pas dans le substrat, qui ne s'en trouve donc pas altéré.

Selon un mode de réalisation la couche tampon est au contact direct du substrat. De préférence, la couche tampon est au contact direct de la couche de masquage. La couche tampon a pour avantage de protéger le substrat d'une contamination par les espèces de la couche de masquage lors de l'implantation. Avec une solution différente de l'invention et qui ne prévoit pas de couche tampon, lorsque la couche de masquage est une couche carbonée, les atomes de carbone peuvent, lors de l'implantation, être arrachés à la couche de masquage et pénétrer dans le substrat. Ces atomes de carbone peuvent alors former à la surface du substrat une fine couche carbonée qui résiste à la porosification. Avant l'étape de retrait par électrochimie, il faut alors retirer du substrat la fine couche de carbone ce qui permet à la porosification de s'effectuer efficacement.

Avantageusement, le procédé comprend, avant l'étape de plongée et l'étape de retrait, une étape de retrait de la couche tampon.

Selon un mode de réalisation, le procédé comprend, avant l'étape de plongée et l'étape de retrait, une étape de retrait de la couche de masquage.

De préférence, on retire également de la face avant du substrat toute autre couche recouvrant cette dernière, par exemple une couche tampon.

Ainsi, la face avant du substrat est mise entièrement à nu avant l'étape de plongée du substrat.

Selon un mode de réalisation, l'étape de plongée du substrat est effectuée de manière à ce qu'à la fois la face avant et la face arrière du substrat soient au contact, de préférence simultanément, de l'électrolyte.

Selon un mode de réalisation, la couche de masquage comprend plusieurs niveaux de hauteur. La couche de masquage comprend des régions adjacentes présentant des niveaux de hauteur différents.

Selon un exemple, un niveau de hauteur peut être non nul et un niveau de hauteur peut être nul. La couche de masquage présente donc des motifs en deux dimensions. Par exemple, l'étape de définition de l'au moins un motif de masque dans la couche de masquage est effectué de sorte que la couche de masquage comprenne au moins une première région présentant un niveau de hauteur non nul et au moins une deuxième région, contigüe à la première région et présentant un niveau de hauteur nul.

Selon un autre exemple, les deux régions adjacentes présentent des niveaux de hauteur différents et non nuls. La couche de masquage présente donc des motifs en 3 dimensions. Par exemple, l'étape de définition de l'au moins un motif de masque dans la couche de masquage est effectué de sorte que la couche de masquage comprenne au moins une première région présentant un premier niveau de hauteur non nul et au moins une deuxième région, contigüe à la première région et présentant un deuxième niveau de hauteur, non nul et différent du premier niveau de hauteur. Ainsi; la couche de masquage comprend plusieurs niveaux de hauteur (différents et) non nuls.

Selon un exemple, la couche de masquage est conformée et l'implantation ionique est effectuée, de sorte à former dans le substrat au moins deux premières zones contigües et présentant des profondeurs d'implantation différentes et non nulles. Ainsi lesdites premières zones contigües forment un motif en trois dimensions.

Selon un mode de réalisation, on peut avoir sur la face avant d'un même substrat des motifs en trois dimensions et des motifs en deux dimensions.

Selon un exemple, l'étape de retrait de l'au moins une première zone sélectivement à l'au moins une deuxième zone est effectuée de sorte à former sur la face avant du substrat au moins un motif fonction du motif de masque. Le motif de masque et le motif formé dans le substrat peuvent être isométriques ou non. Ils sont par exemple proportionnels.

Selon un exemple, le matériau de la couche de masquage et le matériau du substrat sont choisis de sorte que la pénétration des ions au sein de ces matériaux permette que ledit motif formé sur la face avant du substrat à l'issue de l'étape de retrait soit identique (c'est-à-dire qu'il présente des formes et des dimensions identiques) audit motif de masque ou qu'il soit différent tout en présentant des dimensions proportionnelles à celles du motif de masque.

Selon un mode de réalisation, le substrat est fait d'un matériau semi-conducteur.

Selon un mode de réalisation, le substrat est à base de silicium (Si) et de préférence est fait uniquement de silicium. Selon un mode de réalisation, le substrat est de préférence monocristallin.
Selon un mode de réalisation, durant l'étape d'électrochimie, on maintient une intensité constante du courant passant entre une anode formée en partie au moins par le substrat et une cathode plongée dans l'électrolyse, on surveille l'évolution de la tension entre l'anode et la cathode. Cette tension évolue lors de l'anodisation. Quand elle se stabilise, cela signifie que la totalité de l'au moins une première zone a été rendue poreuse.

Ainsi, il est possible de contrôler avec précision que toute l'au moins une première zone modifiée lors de l'implantation a été rendue poreuse. On peut ainsi interrompre l'étape d'électrolyse.

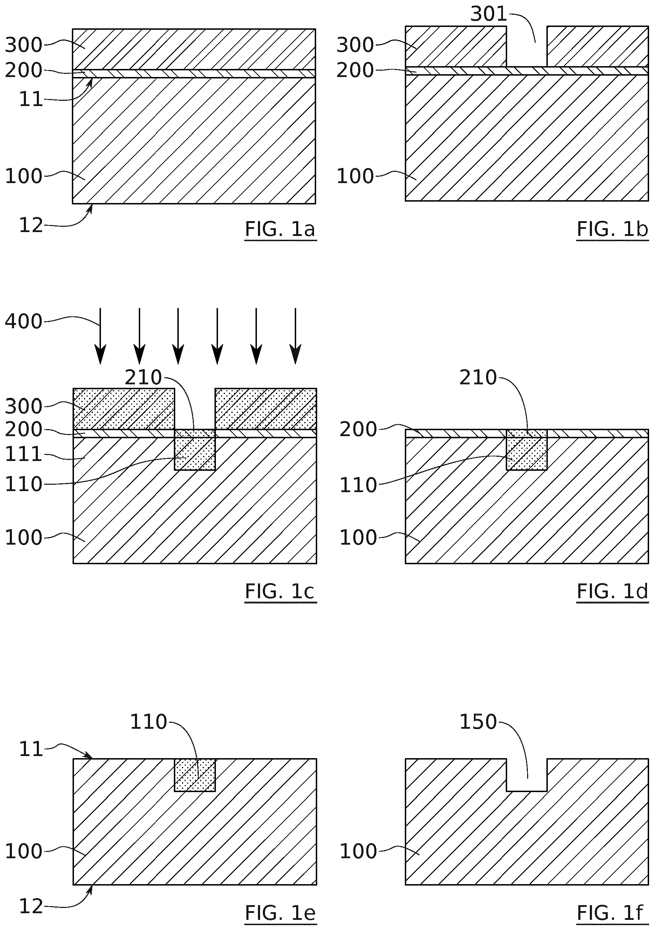

Un exemple de réalisation de la présente invention va maintenant être décrit en référence aux figures 1a à 1f.

Comme illustré en figure 1a, on réalise un empilement comprenant un substrat 100 présentant une face arrière 12 et une face avant 11, la face avant 11 étant recouverte d'une couche de masquage 300. On prévoit au moins une couche tampon 200 entre le substrat 100 est la couche de masquage 300.

Typiquement, le substrat 100 est réalisé en un matériau semi-conducteur. Il s'agit de préférence d'un matériau à base de silicium, par exemple monocristallin ou polycristallin.

La couche de masquage 300 peut être soit une couche de résine soit un masque dur, par exemple un masque de nitrure.

La couche de masquage 300 peut-être une couche monolithique. Alternativement elle peut être formée d'un empilement de plusieurs films.

De même la couche tampon 200 peut-être une couche monolithique ou, alternativement, être formée d'un empilement de plusieurs films. La couche tampon 200 est par exemple faite d'un oxyde ou d'un nitrure du matériau constituant le substrat. Typiquement il s'agit d'un oxyde de silicium (SixOy) tel que le SiO2 ou d'un nitrure de silicium (SixNy) tel que le SiN. Elle présente par exemple une épaisseur comprise entre 10 et 20 nanomètres.

Comme illustré en figure 1b, on réalise dans la couche de masquage 300 au moins un motif 301, appelé motif de masquage. Ce motif 301 peut-être réalisé par tous les moyens classiques de lithographie : lithographie optique, lithographie électronique, lithographie par nano impression. Il peut également être effectué par la technique d'auto assemblage directe (DSA acronyme de Direct Self Assembled). Dans le mode de réalisation illustrée en figure 1b, le motif 301 informe un creux et toute l'épaisseur de la couche de masquage 300 est retirée au niveau du motif de masquage 301. Selon un autre mode de réalisation une épaisseur résiduelle de la couche masquage 300 subsistait dans le fond du motif de masquage 301. Telle serait notamment le cas si le motif 301 est obtenu par nano impression.

Dans l'exemple illustré en figure 1b, le motif de masque 301 présente deux régions contiguës de hauteur différentes, la hauteur (correspondant ici à l'épaisseur) étant prise selon une direction perpendiculaire au plan principal dans lequel s'étend le substrat 100. L'une de ces hauteurs est nulle (creux du motif 301) et l'autre de ces hauteurs est non nulle. La frontière entre ces deux régions contiguës est le flanc vertical du motif 301. Ainsi, le motif de masque 301 est un motif en deux dimensions.

La figure 1c illustre une étape de modification localisée du substrat 100. Cette modification s'effectue par une implantation ionique du substrat 100 par sa face avant 11 et au moins au droit du motif de masquage 301. Cette implantation est réalisée au travers de la couche de masquage 300 et au travers de la couche tampon 200. Sur cet exemple, la direction privilégiée d'implantation est perpendiculaire au plan principal dans lequel s'étend le substrat 100 (cette direction est verticale sur les figures illustrées). L'épaisseur de la couche de masquage 300, l'épaisseur de la couche tampon 200, ainsi que les conditions d'implantation, en particulier l'énergie communiquée aux ions et la direction d'implantation, sont choisies de manière à ce qu'au moins au droit du motif 301 des ions pénètrent dans le substrat 300. Ils viennent ainsi modifier une zone 110 du substrat 100. Le reste du substrat 100, c'est-à-dire les portions de substrat qui ne sont pas modifiées par l'implantation ou qui sont modifiées en dessous d'un seuil donné, sont référencées 111 sur les figures.

L'implantation peut être effectuée par tous les moyens classiquement employés pour implanter des ions dans une matière. Ainsi on pourra recourir un implanteur. On pourra également prévoir d'implanter ces ions à partir d'un plasma.

Avantageusement, la couche tampon 200 a pour but d'éviter que, sous l'effet du bombardement ionique, des atomes de la couche de masquage 300 soient arrachés de cette dernière et pénètrent dans le substrat 100.

Puisque la couche de masquage 300 est une résine carbonée, le bombardement ionique peut conduire à arracher les atomes de carbone de cette couche de masquage 300 et à les faire pénétrer dans le substrat 100 si ce dernier n'est pas recouvert d'une couche tampon 200. En l'absence d'une couche tampon 200, il peut alors se former un film carboné à la surface de la face avant 11 du substrat 100. Ce film carboné pourrait alors empêcher la porosification que l'on souhaite provoquer lors de l'étape suivante d'électrochimie.

En dimensionnant correctement l'épaisseur de la couche tampon 200 en fonction de l'énergie d'implantation des ions et en fonction d'une éventuelle couche résiduelle dans le fond des motifs 301 de la couche de masquage 300, on piège au sein de la couche 200 tous les atomes de carbone qui pourraient potentiellement être arrachés à la couche de masquage 300 et qui se dirigeraient vers le substrat 100. La face avant 11 du substrat 100 est alors exemple de toute contamination et on évite la formation d'un film carboné. La portion de la couche tampon 200 au sein de laquelle se trouve piégés les atomes arrachés à la couche de masquage 300 est référencée 210 en figure 1c.

Naturellement, il se peut que des ions pénètrent involontairement dans le substrat 100 dans des zones où il n'était pas souhaité qu'ils pénètrent, notamment à la frontière entre les zones 110 et les zones 111. Ainsi, de manière générale, les zones 111 sont des zones non d'implantées ou présentant une concentration en ions implantés bien plus faible que les zones 110. Par souci de concision, dans la suite de la description, les zones 111 sont qualifiées de zones non d'implantées que ces zones reçoivent effectivement aucun ion ou qu'elles en reçoivent peu.

L'implantation est effectuée de manière à ce que la résistivité p1 des zones implantées 110 soit inférieure à la résistivité p2 des zones 111 non implantées. Plus précisément, les conditions d'implantation, en particulier la nature des ions implantés et la dose implantée sont telles que p2 ≥ 1.1*p1 et de préférence p2 ≥ 2*p1 et de préférence p2 ≥ 3*p1.

Dans le cadre de la présente invention, les résistivités p1 et p2 seront par exemple, déterminées par la méthode SSRM, acronyme de « Scanning Spreading Résistance Microscopy », bien connue de l'homme du métier.

Afin d'obtenir dans les zones modifiées 110 une résistivité p1 présentant une valeur souhaitée, l'homme du métier jouera notamment sur la nature des ions, la dose d'implantation et surtout l'énergie d'implantation.

Une implantation à forte énergie d'ions légers peut mener à une augmentation de la résistivité, ce qui va l'encontre du but recherché. En particulier, pour un substrat de silicium et pour une implantation à base d'hélium ou d'hydrogène, l'énergie maximale est de 150keV.

L'homme du métier saura adapter les conditions d'implantation, notamment l'énergie de l'implantation pour que l'implantation conduise effectivement à une réduction de la résistivité et non pas à son augmentation.

Ainsi, l'implantation vise à créer localement des défauts dans le matériau du substrat 100 afin de réduire localement sa résistivité. Les régions dont la résistivité est réduite correspondent aux zones modifiées 110. Ces régions à résistivité réduite présentent une géométrie identique à celle des motifs de masquage 301 réalisés dans la couche masquage 300. Tout au moins, ces régions à résistivité réduite présentent une géométrie qui est fonction de celle des motifs de masquage 301 réalisés dans la couche masquage 300.

Ainsi, on peut considérer que le substrat 100 présente une première zone modifiée 110 dont la profondeur est non nulle et une deuxième zone 111 non modifiée ou modifiée sur une profondeur nulle. Cette première zone 110 forme donc un motif en deux dimensions.

Comme illustré en figures 1d et 1e, la couche de masquage 300 et la couche tampon 200 sont retirées. En fonction de la nature des matériaux de ces deux couches, ces retraits peuvent être effectués successivement comme illustré dans ce mode de réalisation ou être effectué simultanément. Selon un mode de réalisation alternative, on peut retirer la couche masquage 300 et conserver la couche tampon 200.

On obtient donc en figure 1e un substrat 100 présentant au moins une zone 110 modifiée par implantation dont la résistivité p1 est plus faible que celle du matériau initial du substrat 100.

L'étape suivante consiste à retirer la zone 110 sélectivement à la zone 111 non modifiée du substrat 100 de manière à obtenir le résultat final illustré en figure 1f.

Pour cela, on prévoit d'effectuer une étape d'électrochimie en plongeant le substrat 100 dans un électrolyte. Le substrat 100 est entièrement plongé dans l'électrolyte. Ainsi, la face avant 11 et la face arrière 12 du substrat 100 sont au contact de l'électrolyte 4.

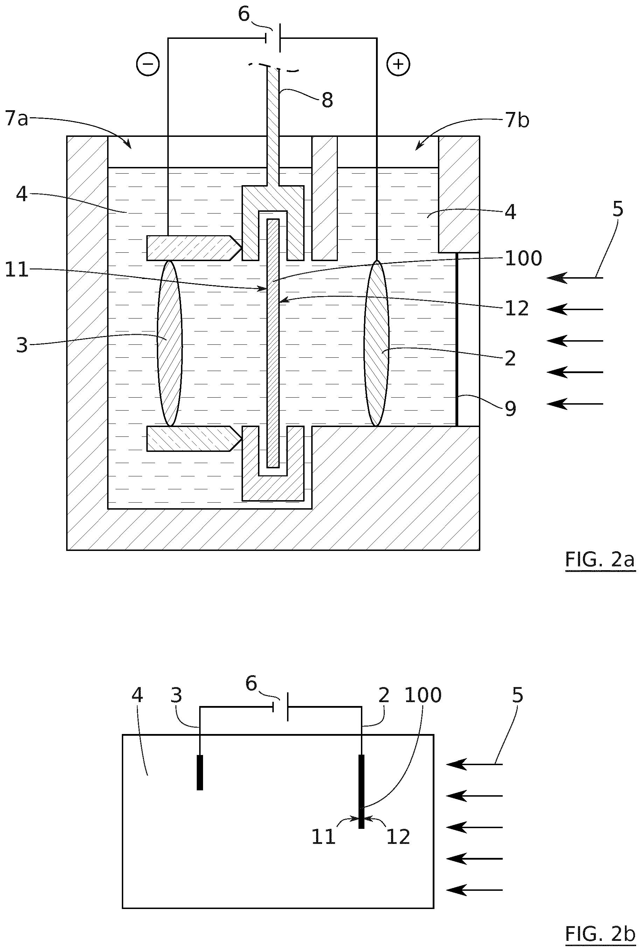

Les figures 2a et 2b illustrent cette étape d'électrochimie.

Chacune des figures 2a et 2b illustre un équipement permettant d'effectuer cette étape d'électrochimie.

Sur ces exemples non limitatifs, le substrat 100 est plongé dans un électrolyte 4 à base d'acide fluorhydrique (HF). Un générateur 6 de courant est connecté à une première électrode (cathode 3) plongée dans l'électrolyte 4 et à une deuxième électrode (anode 3).

L'exemple de la figure 2a correspond à dispositif usuellement appelé montage à double cellule. Ce dispositif comprend deux cellules comprenant chacune une cuve 7a, 7b. De préférence les cuves 7a, 7b contiennent le même électrolyte 4. Les cuves 7a, 7b sont séparées par la plaque ou substrat 100 à traiter. Avantageusement, le substrat 100 assure l'étanchéité entre les deux cuves 7a, 7b. Il est maintenu par un support 8. L'anode 3 est plongée dans l'électrolyte au contact de la face arrière 12 du substrat 100. Selon un mode de réalisation dans lequel le substrat 100 est illuminé (mode de réalisation optionnel), l'anode 3 laisse passer une illumination. A cet effet l'anode 3 peut présenter un pourtour et une zone non opaque voire une ouverture. Elle forme de préférence un anneau et permet le passage de l'illumination en son centre. L'anode 3 et la face 12 du substrat 100 sont alors placés au regard d'une paroi 9 non opaque de la cuve 7b.

La face arrière 12 du substrat 100 joue ici le rôle de la cathode. La face avant 11 du substrat 100 est au contact de l'électrolyte 4 contenue dans l'autre cuve 7a. Cette face avant 11 constitue la face à traiter par porosification. Cette face avant 11 joue le rôle de l'anode.

Selon un exemple de réalisation, en utilisant des substrats de type p (résistivité 1⁻⁵⁰ohm.cm), on favorise la génération des porteurs de charge nécessaires à la porosification par illumination et/ou par dopage (par implantation ionique) en face arrière 12.

L'homme du métier saura adapter les conditions en fonction de la nature des substrats et son dispositif expérimental.

Dans le mode de réalisation illustré en figure 2b, la deuxième électrode (anode 3) est électriquement connectée au substrat 100. Le substrat 100 fait ainsi office d'anode 2. Dans ce mode de réalisation les deux électrodes 3, 4 sont plongées dans une même cuve comportant l'électrolyte.

Comme illustré en figure 2a et 2b :
- on peut appliquer un rayonnement lumineux 5 tout au moins sur la face arrière 12 du substrat 100. Quel que soit le mode de réalisation retenu, par exemple l'un de ceux illustrés en figures 2a et 2b, si une illumination est prévue elle peut s'effectuer par exemple par une lumière blanche. Plus précisément l'illumination est assurée par une source d'illumination comportant des photons dont l'énergie est supérieure au gap du matériau traité, soit, dans le cas du Silicium une énergie supérieure à 1.1eV. Par exemple, la puissance de la lampe est de 3500W.

De préférence, la face arrière 12 du substrat 100 est illuminée pendant l'étape d'électrochimie. Selon un mode de réalisation avantageux, la face arrière 12 du substrat 100 est illuminée pendant toute la durée de l'étape d'électrochimie.
- De manière alternative ou combinée, on peut également prévoir de doper la face arrière 12 du substrat. Ce dopage peut être réalisé après ou avant l'implantation ionique. Il est réalisé avant de plonger le substrat 100 dans l'électrolyte 4. Ce dopage peut être un dopage de type p+. Il peut par exemple être obtenu par deux étapes d'implantation, une premier étape d'implantation au Bore à une dose de 5E15 atm/cm3 et une énergie de 100keV, puis une seconde étape d'implantation au Bore avec une dose de 5E15 atm/cm3 et une énergie 30keV.

La concentration des porteurs en face arrière 12 du substrat 100, ainsi que les conditions de l'électrochimie, en particulier la densité de courant, sont telles que les porteurs de charges en face arrière 12 du substrat se déplacent jusqu'en face avant 11. Le mouvement des porteurs est facilité dans les zones 110 à plus faible résistivité. Les porteurs se dirigent donc principalement vers ces zones 110.

Les conditions d'électrochimie, en particulier la nature de l'électrolyte 4, sont également telles qu'il se produit une porosification du matériau du substrat 100 uniquement dans les zones 110. Quand on se limite au temps nécessaire pour porosifier les zones implantées, la sélectivité est infinie. Alternativement, les conditions d'électrochimie sont telles que la porosification s'effectue préférentiellement dans les zones 110, c'est-à-dire que la porosification se produit à une vitesse plus élevée dans les zones modifiées 110 que dans les zones non modifiées 111.

Ainsi, le but de l'implantation 400 est de créer des défauts localisés dans le substrat 100 afin d'obtenir lors de l'électrochimie une porosification localisée.

L'énergie et la dose d'implantation permettent à la fois de définir la profondeur d'implantation ainsi que les défauts induits (électrique ou morphologique) dans le matériau. L'amorphisation du matériau du substrat 10, typiquement du silicium, n'est pas nécessaire pour engendrer la sélectivité lors de la porosification. En effet, une modification électrique qui réduit la résistivité est suffisante. De ce fait, tous les ions de la table des éléments peuvent être utilisés comme mentionné ci-dessus.
- La figure 3 illustre de manière simplifiée le mécanisme de porosification d'un substrat 100 de silicium dans un électrolyte 30 à base d'acide fluorhydrique (HF). Le substrat 100 est surmonté d'un diélectrique 110 qui masque le substrat 100 en dehors des ouvertures de manière à autoriser la porosification uniquement dans les zones non masquées.

Comme illustré en figure 3a, la dissolution du Si commence par la passivation des liaisons pendantes 34 par les atomes d'hydrogène 32. Ensuite les atomes d'hydrogène 32 sont remplacés par des atomes de fluor 31 (figure 3b). En figure 3b la référence 35 illustre le déplacement des porteurs de charges positives. La polarisation induite par les liaisons Si-F va conduire à la rupture des liaisons Si-Si 33 provoquant de ce fait le dégagement de la molécule Si 36 (figure 3c et 3d). Le type et la taille des pores 102 dépendent des paramètres de porosification et du type de dopage du substrat.

Plus précisément, les paramètres permettant d'anodiser le matériau du substrat 100 et d'obtenir une porosification efficace des zones 110 modifiées sont les suivants :
- la nature du bain chimique.
- la puissance d'illumination. Comme indiqué ci-dessus, ce paramètre permet de générer les porteurs positifs en face arrière 12.
- la densité de courant d'anodisation (A/m²), c'est-à-dire le ratio courant/surface du substrat.
- Le temps pendant lequel la densité de courant est appliquée.

Naturellement, ces paramètres dépendent également de la résistivité initiale du substrat 100 (c'est-à-dire la résistivité du substrat 100 avant l'étape d'implantation), de la résistivité des zones 110 modifiées par implantation, ainsi que de la profondeur de la zone implantée 110 que l'on souhaite rendre poreuse.

Selon un premier mode de réalisation, les conditions d'implantation ainsi que les paramètres de l'étape d'électrochimie sont telles que la porosification des zones 110 permet de retirer entièrement ou partiellement au moins ces zones sélectivement aux zones 111. Les zones implantées 110 se sont ainsi entièrement ou tout au moins partiellement détachées du substrat 100. Ainsi, à l'issue de l'étape d'électrochimie, le substrat 100 ne comprend plus de matière dans les zones 110 préalablement implantées ou en contient moins qu'avant l'anodisation.

De manière optionnelle, dans ce mode de réalisation on effectuera de préférence un nettoyage pour retirer les zones rendues poreuses qui ne se seraient pas détachées du substrat 100. Cette étape fait donc office de nettoyage. On pourra pour cela utiliser des chimies alcalines. Par exemple on pourra utiliser de l'hydroxyde de potassium (KOH) ou de l'hydroxyde de tetramethylammonium (TMAH).

Selon un deuxième mode de réalisation, l'étape d'électrochimie conduit à une porosification sélective des zones 110 par rapport aux zones 111, tout comme le premier mode de réalisation précédent, mais dans ce deuxième mode de réalisation, les zones 110 rendues poreuses restent mécaniquement liées au substrat 100.

Dans ce cas, on peut prévoir une gravure des zones rendues poreuses sélectivement aux zones qui n'ont pas été rendues poreuses. Cette gravure sélective peut être effectuée par une gravure humide par exemple à l'aide d'une chimie comprenant à base de KOH ou TMAH.

En référence à la figure 5, un mode de réalisation de motifs en trois dimensions va maintenant être décrit.

La figure 5a illustre un substrat 100 surmonté d'une couche de masquage 300. Cette dernière présente des motifs en creux 301 et des motifs en saillie 302. Tous ces motifs ont été formés par impression nanométrique de la couche de masquage 300 par le moule 500. La couche de masquage 300 comprend des régions contiguës présentant des niveaux de hauteur différents. La couche de masquage 300 présente ainsi des motifs en trois dimensions.

La figure 5b illustre une étape d'implantation 400 réalisée à travers la couche de masquage 300. Sur cet exemple, les conditions d'implantation sont choisies de manière à ce que les motifs 301, 302 soient reproduits avec les mêmes dimensions dans le substrat 300. Ce mode de réalisation avec transfert isométrique des motifs de masquage n'est que optionnel. Dans cet exemple, les zones 110 modifiées présentes des profondeurs différentes.

La figure 5c illustre l'étape de retrait de la couche masquage 300.

Le substrat 100 subit ensuite l'étape d'électrochimie. Les zones 110 implantées sont rendues poreuses sélectivement aux zones non implantées 111. De préférence, les zones 110 rendues poreuses se détachent automatiquement du substrat 100 lors de l'électrochimie. Alternativement, après l'électrochimie, on effectue un nettoyage humide afin de graver les zones poreuses 110 sélectivement aux zones 111 qui n'ont pas été rendues poreuses.

La figure 5d illustre le résultat final obtenu. Le procédé selon l'invention permet ainsi d'obtenir de manière aisée et reproductible une structuration de la face avant du substrat 100, cette face avant 11 portant des motifs 150 en creux et des motifs en saillie 151, en trois dimensions, dont les géométries sont possiblement complexes.

Dans ce mode réalisation comme dans tous les autres modes de réalisation couverts par les revendications, les motifs finaux obtenus dans le substrat 100 peuvent :
- soit être conformes (en termes de géométrie et/ou de dimensions) aux motifs de masquage 301, 302 formés dans la couche de masquage 300,
- être différents (en termes de géométrie et/ou de dimensions) des motifs de masquage 301, 302 formés dans la couche de masquage 300.

La conformité ou la non-conformité du transfert des motifs depuis la couche de masquage 300 vers le substrat 100 dépend notamment des capacités respectives de leurs matériaux à laisser pénétrer en leur sein les ions lors de l'implantation 400.

Dans la suite de la description, des exemples détaillés avec des valeurs numériques seront présentés. La densité de courant d'anodisation sera renseignée par une intensité exprimée en Ampère. Ces valeurs d'intensité ont été obtenues avec des substrats formant des disques de 200 mm de diamètre. L'homme du métier peut ainsi calculer la densité de courant appliqué dans ces exemples. Il pourra ainsi déterminer l'intensité du courant qu'il faudra appliquer pour des substrats de dimensions différentes.

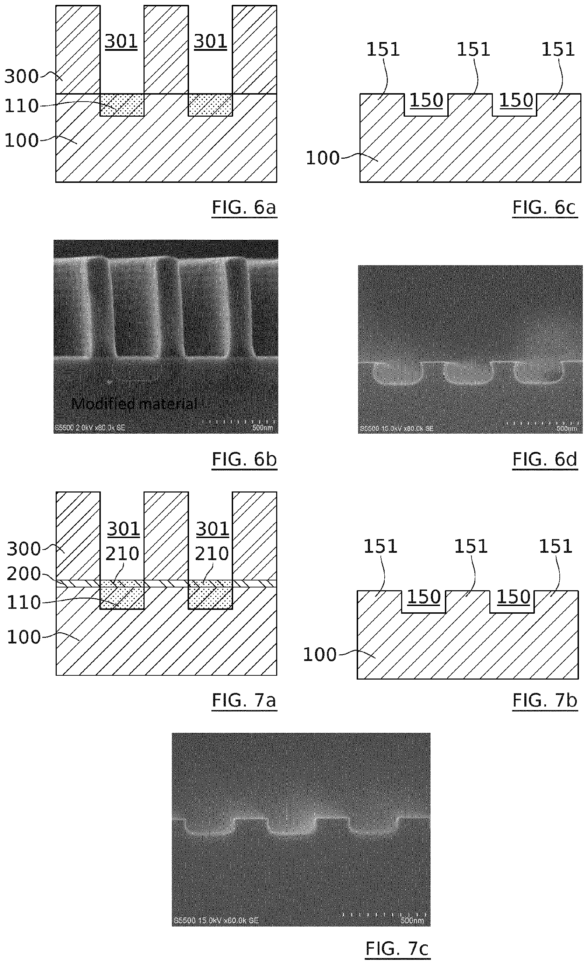

La figure 4 et les paragraphes ci-dessous présentent un exemple de protocole pour définir des conditions d'anodisation du substrat 100. C'est sur la base de ce protocole qu'ont été définies les conditions mentionnées dans les exemples précis mais non limitatifs qui seront décrits en référence aux figures 6 à 8.

Dans cet exemple non limitatif le substrat est un substrat de silicium de type P, dont la résistivité et de 1 à 50 OHM (gamme standard de résistivité pour des plaques de silicium p dopé au bore à environ 2.6.E14 à 1.5E16 at/cm³), dont l'orientation cristalline est (1 0 0). Le substrat présent une forme circulaire (disque) de 200 mm de diamètre.

Afin de définir les conditions d'anodisation des substrats, trois plaques de références ont été traitées dans une cellule électrochimique, dont l'électrolyte est un acide HF dilué à 35%, le solvant étant de l'isopropranol (IPA).

Les plaques sont en contact avec le bain chimique en face avant 11 et arrière 12. On fait varier le potentiel de 0 à 20V, l'évolution du courant est mesurée au fur et à mesure du traitement ce qui permet ainsi de tracer les courbes illustrées en figure 4. Chacune des courbes correspond à un taux d'illumination 20%, 40% et 60% pour une source lumineuse qui délivre une lumière blanche avec une puissance maximale de 3500W. Dans la présente demande de brevet, on qualifie de taux d'illumination la puissance délivrée par la source par rapport à la puissance maximale que cette dernière peut délivrer.

La forme des courbes permet d'identifier la nature du régime dans lequel se trouve le substrat. Ce régime est, soit un régime de porosification (partie croissante de la courbe), soit un régime d'électro-polissage (partie de la courbe présentant une intensité constante).

Avantageusement, les conditions d'électrochimie sont choisies de manière à se situer dans le régime de porosification.

L'illumination est une lumière blanche d'une puissance de 3500W.

Dans cet exemple, on choisit de travailler à 60% d'illumination, c'est-à-dire que la puissance émise par la source lumineuse est de 60 % de sa puissance maximale (soit 60% de 3500W). Cette puissance d'illumination élevée a pour avantage d'augmenter la vitesse de la porosification. En effet, plus le taux d'illumination est élevé plus la vitesse d'anodisation est grande. Une puissance d'illumination plus élevée serait possible mais pourrait potentiellement conduire à des vitesses de porosification élevées et donc à des vitesses de gravure trop rapides pour être maîtrisées de manière stable et reproductible.

Dans cet exemple, on choisit également de se placer dans la zone de porosification à 2A.

Le temps de l'électrochimie est défini grâce une plaque de silicium vierge traitée avec les mêmes paramètres (régime de porosification à 60% d'illumination et à courant constant de 2A). L'étude de l'évolution de l'épaisseur porosifiée en fonction du temps de cette plaque témoin, nous permet d'estimer le temps nécessaire pour traiter une plaque localement implantée à une profondeur variant entre 100 nm et 200 nm.

Plusieurs exemples précis mais non limitatifs vont maintenant être décrits en référence aux figures 6 à 8.

La figure 6 illustre la gravure de motifs en deux dimensions dans un substrat 100 formant une plaque de silicium cristallin. Le substrat 100 est de type P. Il présente une résistivité de 1 à 50 OHM.

Dans cet exemple, la couche de masquage 300 est une résine disposée directement contact du substrat 100. Préalablement à l'étape illustrée en figure 6a, on effectue une lithographie optique classique pour réaliser des motifs 301 en forme de lignes parallèles.

On effectue ensuite une implantation d'ions argon, avec les conditions suivantes:

| Nature des ions | Energie des ions | Dose |
|---|---|---|
| Argon (Ar) | 100kev | 1.E16at/cm² |

Pour cet exemple il n'est pas nécessaire de faire un dépôt de couche tampon 200, et si aucune couche tampon n'est présente alors le mode de réalisation ne fait pas partie de l'invention.

Les figures 6a et 6b illustrent, respectivement de manière schématique et par une photographie par microscope électronique, le résultat obtenu à l'issue de l'étape d'implantation.

On effectue ensuite une étape de retrait de la couche de masquage 300. Puis on effectue l'étape d'anodisation du substrat 100 avec illumination de la face arrière 12 du substrat 100. Les conditions de l'électrochimie sont les suivantes :

| Intensité (Ampères) | Nature de l'électrolyte (à base de) | Taux d'illumination (% de la puissance maximale de la source) | Durée de l'électrochimie (secondes) |
|---|---|---|---|
| 2 A | HF35 % | 60% | 30 s |

Pour les conditions de ce mode de réalisation et de ceux des figures qui suivent, on rappellera que les valeurs mentionnées pour les intensités ont été obtenues avec des substrats formant des disques de 200 mm de diamètre. Par ailleurs, on rappellera que la puissance maximale de la source, dans ces exemples est de 3500W.

Les figures 6c et 6d illustrent, respectivement de manière schématique et par une photographie par microscope électronique, le résultat obtenu à l'issue de l'étape de retrait comprenant l'électrochimie.

De manière particulièrement avantageuse, les zones rendues poreuses se détachent d'elles-mêmes lors de l'électrochimie.

Pour ce mode de réalisation comme pour tous les modes de réalisation, durant l'étape d'électrochimie, on peut ;
- maintenir une intensité constante du courant passant entre une anode formée par le substrat 100 et une cathode plongée dans l'électrolyse,
- surveiller l'évolution de la tension entre l'anode et la cathode.

Si une stabilisation de l'intensité ou si une variation d'intensité d'un facteur k est détectée alors, on en déduit que la totalité de l'au moins une première zone a été rendue poreuse.

On notera qu'il est également possible de procéder de manière inverse c'est-à-dire en fixant la tension et en surveillant l'évolution de l'intensité.

Ainsi, il est possible de contrôler avec précision que toute la zone modifiée 110 lors de l'implantation a été rendue poreuse et a été possiblement retirée. On peut ainsi interrompre l'étape d'électrolyse.

La figure 7 illustre la gravure de motifs en deux dimensions dans un substrat 100 identique à celui de l'exemple précédent.

L'empilement de cet exemple diffère de celui de la figure 6 en ce qu'on dispose une couche tampon 200 entre le substrat 100 et la couche de masquage 300. Cette couche tampon 200 est formée par un dépôt de nitrure (par exemple mais de manière non limitative de nitrure de silicium SiN), de préférence par LPCVD (dépôt chimique en phase valeur à basse température). L'épaisseur de cette couche 200 est de 20 nm (10⁻⁹ mètres).

Préalablement à l'étape illustrée en figure 7a, on effectue une lithographie optique classique pour réaliser les motifs 301 en forme de lignes parallèles.

On effectue ensuite une implantation d'ions d'argon dans les conditions suivantes :

| Nature des ions | Energie des ions | Dose |
|---|---|---|
| Argon (Ar) | 100kev | 1.E15at/cm² |

La figure 7a illustre de manière schématique le résultat obtenu à l'issue de l'étape d'implantation. Les zones 110 du substrat 100 ainsi que la zone 210 de la couche tampon 200 situées au droit des ouvertures 301 de la couche de masquage 300 sont implantées.

On effectue ensuite une étape de retrait de la couche de masquage 300 et une étape de retrait de la couche tampon 200. Puis on effectue l'étape d'anodisation du substrat 100 avec illumination de la face arrière 12 du substrat 100. Les conditions d'électrochimie sont les suivantes :

| Intensité (Ampères) | Nature de l'électrolyte (à base de) | Taux d'illumination (% de la puissance maximale de la source) | Durée de l'électrochimie (secondes) |
|---|---|---|---|
| 2 A | HF35 % | 40% | 10 s |

La figure 7c illustre de manière schématique le résultat obtenu à l'issue de l'étape de retrait comprenant l'électrochimie.

De manière particulièrement avantageuse, les zones rendues poreuses se détachent d'elles-mêmes lors de l'électrochimie.

La figure 8 illustre la gravure de motifs en trois dimensions dans un substrat 100 identique à celui de l'exemple illustré en figure 6.

Dans cet exemple non limitatif et non revendiqué, la couche de masquage 300 est une résine disposée directement contact du substrat 100, sans couche tampon 200 intermédiaire.

Préalablement à l'étape illustrée en figure 8a, on réalise des motifs 300a-300e qui définissent ensemble un profil en marche d'escalier. Ce profil est de préférence obtenu par impression nanomètres nanométrique. Ainsi, la couche de masquage 300 présente des régions 300a, 300b (...) contigües de hauteurs différentes, c'est-à-dire d'épaisseurs différentes.

Comme illustrée en figure 8b, on effectue ensuite une implantation d'ions d'argon avec les conditions suivantes :

| Nature des ions | Energie des ions | Dose |
|---|---|---|
| Argon (Ar) | 150kev | 1.E16at/cm² |

On obtient ainsi dans le substrat 100 des zones implantées 110 qui sont fonctions des motifs 300a à 300e. Les zones implantées contiguës présentent des profondeurs différentes d'implantation.

L'étape suivante, illustrée en figure 8c de manière schématique et par une photographie par microscope électronique, consiste à retirer la couche de masquage 300.

Puis on effectue l'étape d'anodisation du substrat 100 avec illumination de la face arrière 12 du substrat 100. Les conditions d'électrochimie sont les suivantes :

| Intensité (Ampères) | Nature de l'électrolyte (à base de) | Taux d'illumination (% de la puissance maximale de la source) | Durée de l'électrochimie (secondes) |
|---|---|---|---|
| 2 A | HF35 % | 60% | 30 s |

La figure 8d illustre, de manière schématique et par une photographie par microscope électronique, le résultat obtenu à l'issue de l'étape de retrait comprenant l'électrochimie. Sur cette figure 8d, le substrat 100 présente des motifs contigus 100a, 100b (...) présentant des profondeurs différentes. On obtient ainsi une structuration en trois dimensions de la face avant du substrat 100.

De manière particulièrement avantageuse, les zones rendues poreuses se détachent d'elles-mêmes lors de l'électrochimie.

Au vu de la description qui précède, il apparaît clairement que l'invention propose une solution particulièrement efficace, pour structurer en épaisseur la face avant d'un substrat en formant sur face avant des motifs aux formes possiblement complexes, avec un bon contrôle dimensionnel et avec des risques réduits d'endommager ou de contaminer des couches sous-jacentes au substrat que l'on souhaite graver. Par ailleurs, les motifs réalisés dans le substrat présentent les mêmes propriétés que le substrat en début de procédé.

La présente invention s'avère donc particulièrement avantageuse pour la réalisation de dispositifs microélectroniques, électroniques, micromécaniques, électromécaniques (MEMS, NEMS...), microfluidiques, optiques ou optoélectroniques.

L'invention n'est pas limitée aux modes de réalisations précédemment décrits et s'étend à tous les modes de réalisation couverts par les revendications.

## Revendications

1. Procédé de structuration de la face avant (11) d'un substrat (100) par réalisation d'au moins un motif (150) sur la face avant (11) du substrat (100), le procédé comprenant au moins les étapes suivantes:
- fournir un substrat (100) présentant une face avant (11) surmontée au moins d'une couche de masquage (300) comprenant des atomes de carbone,
- définir au moins un motif de masque (301) dans la couche de masquage (300) de sorte que la couche de masquage (300) comprenne des régions contiguës présentant des niveaux de hauteur différents,
- réaliser une implantation ionique du substrat (100) par ladite face avant (11) et au moins au droit du motif de masque (301), de manière à former au moins une première zone (110) modifiée par implantation et au moins une deuxième zone (111) non modifiée par l'implantation ou moins modifiée que la première zone (110), les conditions d'implantation étant choisies de manière à ce que après implantation l'au moins une première zone (110) présente une résistivité p1 inférieure à la résistivité p2 de l'au moins une deuxième zone (111),
- retirer la couche de masquage (300) de sorte que la face avant (11) du substrat (100) soit mise à nu,
**caractérisé en ce qu'**il comprend ensuite au moins les étapes successives suivantes:
- après l'étape d'implantation, plonger le substrat (100) dans un électrolyte (4) de sorte que la face avant (11) du substrat (100) mise à nu soit entièrement au contact de l'électrolyte (4),
- retirer l'au moins une première zone (110) sélectivement à l'au moins une deuxième zone (111) de sorte à former sur la face avant (11) du substrat au moins un motif (150) dont la géométrie est fonction du motif de masque (301), l'étape de retrait comprenant au moins l'application au substrat (100) d'une étape d'électrochimie pour provoquer une porosification de l'au moins une première zone (110) sélectivement à l'au moins une deuxième zone (111), l'étape de retrait étant effectuée de manière à ce qu'au moins lors de l'étape d'électrochimie au moins une face arrière (12) du substrat (100) opposée à la face avant (11) présente des porteurs de charges.
et **caractérisé en ce que**
- lors de l'étape d'implantation, le substrat (100) est surmonté d'une couche tampon (200) située entre la face avant (11) du substrat et la couche de masquage (300), la couche tampon (200) étant conformée de manière à piéger les atomes de carbone qui seraient arrachés à la couche de masquage (300) lors de ladite implantation ionique.

2. Procédé selon la revendication précédente, dans lequel l'implantation est réalisée de manière à ce que p2 ≥ 1.1*p1, de préférence de manière à ce que p2 ≥ 2*p1 et de préférence de manière à ce que p2 ≥ 3*p1.

3. Procédé selon l'une quelconque des revendications précédentes, dans lequel l'électrochimie est réalisée de manière à ce que ladite porosification des zones modifiées (110) entraîne un détachement complet de l'au moins une première zone (110) par rapport à l'au moins une deuxième zone (111).

4. Procédé selon l'une quelconque des revendications 1 à 2, dans lequel l'électrochimie est réalisée de manière à ce que ladite porosification des zones modifiées (110) n'entraîne pas un détachement complet de l'au moins une première zone (110) par rapport à l'au moins une deuxième zone (111) et l'étape de retrait comprend également, après l'étape électrochimie, une étape de gravure de l'au moins une première zone (110) rendue poreuse sélectivement à l'au moins une deuxième zone (111).

5. Procédé selon l'une quelconque des revendications 1 à 2, dans lequel ladite implantation ionique du substrat (100) est réalisée de manière à former plusieurs premières zones (110) modifiées par implantation, et dans lequel l'électrochimie est réalisée de manière à ce que ladite porosification des zones modifiées (110) :
- entraîne un détachement complet de certaines seulement desdites plusieurs premières zones (110) par rapport à l'au moins une deuxième zone (111),
- n'entraîne pas un détachement complet des autres premières zones (110) par rapport à l'au moins une deuxième zone (111) et l'étape de retrait comprend également, après l'étape électrochimie, une étape de gravure desdites autres premières zones (110).

6. Procédé selon l'une quelconque des revendications précédentes, dans lequel les ions implantés lors de l'implantation sont pris parmi : des ions dont la masse atomique est supérieure à la masse atomique du bore, les ions à base d'hydrogène (H) et les ions à base d'hélium (He).

7. Procédé selon l'une quelconque des revendications précédentes, dans lequel l'implantation ionique du substrat (100) est réalisée de manière à ce que les ions soient implantés avec une énergie inférieure ou égale à 150keV.

8. Procédé selon l'une quelconque des revendications précédentes, dans lequel l'étape de retrait comprend une gravure humide sélective de l'au moins une première zone (110) rendue poreuse sélectivement à l'au moins une deuxième zone (111) et lequel la gravure humide est de préférence réalisée en milieu alcalin, de préférence à base de l'une des solutions suivantes: l'hydroxyde de potassium (KOH) ou de l'hydroxyde de tetramethylammonium (TMAH).

9. Procédé selon l'une quelconque des revendications précédentes, dans lequel l'étape de retrait comprend une illumination de la face arrière (12) du substrat (100) de manière à ce que la face arrière (12) du substrat présente des porteurs de charges lors de l'étape d'électrochimie, l'illumination étant de préférence effectuée pendant l'étape d'électrochimie.

10. Procédé selon l'une quelconque des revendications précédentes, comprenant, avant l'étape de plongée substrat (100) dans l'électrolyte, une étape de dopage de la face arrière (12) de manière à ce que la face arrière (12) du substrat présente des porteurs de charges lors de l'étape d'électrochimie.

11. Procédé selon l'une quelconque des revendications précédentes, dans lequel l'étape de définition de l'au moins un motif de masque (301) dans la couche de masquage (300) est effectué de sorte que la couche de masquage (300) comprenne au moins une première région présentant un niveau de hauteur non nul et au moins une deuxième région, contigüe à la première région et présentant un niveau de hauteur nul, lesdites première et deuxième régions définissant dans la couche de masquage (300) au moins un motif de masque (301) en deux dimensions.

12. Procédé selon l'une quelconque des revendications précédentes, dans lequel l'étape de définition de l'au moins un motif de masque (301) dans la couche de masquage (300) est effectué de sorte que la couche de masquage (300) comprenne au moins une première région présentant un premier niveau de hauteur non nul et au moins une deuxième région, contigüe à la première région et présentant un deuxième niveau de hauteur non nul et différent du premier niveau de hauteur, lesdites première et deuxième régions définissant dans la couche de masquage (300) au moins un motif de masque (301) en trois dimensions.

13. Procédé selon l'une quelconque des revendications précédentes, dans lequel la couche de masquage (300) est conformée et l'implantation ionique est effectuée de sorte à former dans le substrat (100) au moins deux premières zones (110) contigües et présentant des profondeurs d'implantation différentes et non nulles.

14. Procédé selon l'une quelconque des revendications précédentes, dans lequel durant l'étape d'électrochimie, on maintient une intensité constante du courant passant entre une anode (2) formée en partie au moins par le substrat (100) et une cathode (3) plongée dans l'électrolyse (4), on surveille l'évolution de la tension entre l'anode (2) et la cathode (3), et lorsqu'une stabilisation est détectée, on en déduit que la totalité de l'au moins une première zone (111) a été rendue poreuse.

15. Procédé selon l'une quelconque des revendications précédentes, configuré de sorte que ledit motif (150) formé sur la face avant (11) du substrat (100) à l'issue de l'étape de retrait présente des dimensions proportionnelles à celles du motif de masque (301) et de préférence configuré de sorte que ledit motif (150) formé sur la face avant (11) du substrat (100) à l'issue de l'étape de retrait soit identique audit motif de masque (301).

## Patentansprüche

1. Verfahren zum Strukturieren der Vorderseite (11) eines Substrats (100) durch Ausführen mindestens eines Musters (150) auf der Vorderseite (11) des Substrats (100), wobei das Verfahren mindestens die folgenden Schritte umfasst:
- Bereitstellen eines Substrats (100) mit einer Vorderseite (11), die von mindestens einer Maskierungsschicht (300) überzogen ist, die Kohlenstoffatome umfasst,
- Definieren mindestens eines Maskenmusters (301) in der Maskierungsschicht (300), sodass die Maskierungsschicht (300) aneinandergrenzende Bereiche mit unterschiedlichen Höhenniveaus umfasst,
- Ausführen einer Ionenimplantation des Substrats (100) durch die Vorderseite (11) und mindestens am Maskenmuster (301), um mindestens eine durch Implantation modifizierte erste Zone (110) und mindestens eine zweite Zone (111) zu bilden, die nicht durch die Implantation modifiziert oder weniger modifiziert ist als die erste Zone (110), wobei die Implantationsbedingungen so gewählt werden, dass die mindestens eine erste Zone (110) nach der Implantation einen spezifischen Widerstand p1 aufweist, der kleiner ist als der spezifische Widerstand p2 der mindestens einen zweiten Zone (111),
- Entfernen der Maskierungsschicht (300), sodass die Vorderseite (11) des Substrats (100) freigelegt wird,
**dadurch gekennzeichnet, dass** es anschließend mindestens die folgenden aufeinanderfolgenden Schritte umfasst:
- Eintauchen des Substrats (100) nach dem Implantationsschritt in einen Elektrolyten (4), sodass sich die freiliegende Vorderseite (11) des Substrats (100) vollständig mit dem Elektrolyten (4) in Kontakt befindet,
- Entfernen der mindestens einen ersten Zone (110) selektiv zur mindestens einen zweiten Zone (111), um auf der Vorderseite (11) des Substrats mindestens ein Muster (150) zu bilden, dessen Geometrie vom Maskenmuster (301) abhängt, wobei der Schritt des Entfernens mindestens das Anwenden eines elektrochemischen Schritts auf das Substrat (100) umfasst, um eine Porosifizierung der mindestens einen ersten Zone (110) selektiv zur mindestens einen zweiten Zone (111) zu bewirken, wobei der Schritt des Entfernens so erfolgt, dass mindestens eine der Vorderseite (11) gegenüberliegende Rückseite (12) des Substrats (100) mindestens beim elektrochemischen Schritt Ladungsträger aufweist,
und **dadurch gekennzeichnet, dass**
- das Substrat (100) beim Implantationsschritt von einer Pufferschicht (200) überzogen ist, die sich zwischen der Vorderseite (11) des Substrats und der Maskierungsschicht (300) befindet, wobei die Pufferschicht (200) so gestaltet ist, dass sie die Kohlenstoffatome, die bei der Ionenimplantation aus der Maskierungsschicht (300) gerissen werden, fängt.

2. Verfahren nach dem vorstehenden Anspruch, wobei die Implantation so ausgeführt wird, dass p2 ≥ 1,1*p1, vorzugsweise so, dass p2 ≥ 2*p1, und vorzugsweise so, dass p2 ≥ 3*p1.

3. Verfahren nach einem der vorstehenden Ansprüche, wobei die Elektrochemie so ausgeführt wird, dass die Porosifizierung der modifizierten Zonen (110) zu einer vollständigen Ablösung der mindestens einen ersten Zone (110) in Bezug auf die mindestens eine zweite Zone (111) führt.

4. Verfahren nach einem der Ansprüche 1 bis 2, wobei die Elektrochemie so ausgeführt wird, dass die Porosifizierung der modifizierten Zonen (110) zu keiner vollständigen Ablösung der mindestens einen ersten Zone (110) in Bezug auf die mindestens eine zweite Zone (111) führt, und der Schritt des Entfernens nach dem elektrochemischen Schritt ebenfalls einen Schritt des Ätzens der mindestens einen porös gemachten ersten Zone (110) selektiv zur mindestens einen zweiten Zone (111) umfasst.

5. Verfahren nach einem der Ansprüche 1 bis 2, wobei die Ionenimplantation des Substrats (100) so ausgeführt wird, dass mehrere durch Implantation modifizierte erste Zonen (110) gebildet werden, und wobei die Elektrochemie so ausgeführt wird, dass die Porosifizierung der modifizierten Zonen (110):
- zu einer vollständigen Ablösung nur gewisser der mehreren ersten Zonen (110) in Bezug auf die mindestens eine zweite Zone (111) führt,
- zu keiner vollständigen Ablösung der anderen ersten Zonen (110) in Bezug auf die mindestens eine zweite Zone (111) führt, und der Schritt des Entfernens nach dem elektrochemischen Schritt ebenfalls einen Schritt des Ätzens der anderen ersten Zonen (110) umfasst.

6. Verfahren nach einem der vorstehenden Ansprüche, wobei die bei der Implantation implantierten Ionen ausgewählt sind aus: Ionen, deren Atommasse größer ist als die Atommasse von Bor, Ionen auf Basis von Wasserstoff (H) und Ionen auf Basis von Helium (He).

7. Verfahren nach einem der vorstehenden Ansprüche, wobei die Ionenimplantation des Substrats (100) so ausgeführt wird, dass die Ionen mit einer Energie von kleiner oder gleich 150 keV implantiert werden.

8. Verfahren nach einem der vorstehenden Ansprüche, wobei der Schritt des Entfernens ein selektives Nassätzen der mindestens einen porös gemachten ersten Zone (110) selektiv zur mindestens einen zweiten Zone (111) umfasst, und wobei das Nassätzen vorzugsweise in alkalischem Medium, vorzugsweise auf Basis einer der folgenden Lösungen ausgeführt wird: Kaliumhydroxid (KOH) oder Tetramethylammoniumhydroxid (TMAH).

9. Verfahren nach einem der vorstehenden Ansprüche, wobei der Schritt des Entfernens ein Beleuchten der Rückseite (12) des Substrats (100) umfasst, sodass die Rückseite (12) des Substrats beim elektrochemischen Schritt Ladungsträger aufweist, wobei das Beleuchten vorzugsweise während des elektrochemischen Schritts erfolgt.

10. Verfahren nach einem der vorstehenden Ansprüche, das vor dem Schritt des Eintauchens des Substrats (100) in den Elektrolyten einen Schritt des Dotierens der Rückseite (12) umfasst, sodass die Rückseite (12) des Substrats beim elektrochemischen Schritt Ladungsträger aufweist.

11. Verfahren nach einem der vorstehenden Ansprüche, wobei der Schritt des Definierens des mindestens einen Maskenmusters (301) in der Maskierungsschicht (300) so erfolgt, dass die Maskierungsschicht (300) mindestens einen ersten Bereich mit einem Höhenniveau von ungleich Null und mindestens einen zweiten Bereich umfasst, der an den ersten Bereich angrenzt und ein Höhenniveau von Null aufweist, wobei der erste und zweite Bereich mindestens ein zweidimensionales Maskenmuster (301) in der Maskierungsschicht (300) definieren.

12. Verfahren nach einem der vorstehenden Ansprüche, wobei der Schritt des Definierens des mindestens einen Maskenmusters (301) in der Maskierungsschicht (300) so erfolgt, dass die Maskierungsschicht (300) mindestens einen ersten Bereich mit einem ersten Höhenniveau von ungleich Null und mindestens einen zweiten Bereich umfasst, der an den ersten Bereich angrenzt und ein zweites Höhenniveau von ungleich Null aufweist, das sich vom ersten Höhenniveau unterscheidet, wobei der erste und zweite Bereich mindestens ein dreidimensionales Maskenmuster (301) in der Maskierungsschicht (300) definieren.

13. Verfahren nach einem der vorstehenden Ansprüche, wobei die Maskierungsschicht (300) so gestaltet ist und die Ionenimplantation so erfolgt, dass mindestens zwei aneinandergrenzende erste Zonen (110) mit unterschiedlichen Implantationstiefen von ungleich Null im Substrat (100) gebildet werden.

14. Verfahren nach einem der vorstehenden Ansprüche, wobei während des elektrochemischen Schritts eine konstante Stärke des Stroms beibehalten wird, der zwischen einer mindestens zum Teil vom Substrat (100) gebildeten Anode (2) und einer in den Elektrolyten (4) getauchten Kathode (3) fließt, die Entwicklung der Spannung zwischen der Anode (2) und der Kathode (3) überwacht wird, und wenn eine Stabilisierung erkannt wird, daraus abgeleitet wird, dass die Gesamtheit der mindestens einen ersten Zone (111) porös gemacht wurde.

15. Verfahren nach einem der vorstehenden Ansprüche, das so ausgelegt ist, dass das am Ende des Entfernungsschritts auf der Vorderseite (11) des Substrats (100) gebildete Muster (150) Abmessungen aufweist, die zu denen des Maskenmusters (301) proportional sind, und das vorzugsweise so ausgelegt ist, dass das am Ende des Entfernungsschritts auf der Vorderseite (11) des Substrats (100) gebildete Muster (150) mit dem Maskenmuster (301) identisch ist.

## Claims

1. A method for structuring the front face (11) of a substrate (100) by producing at least one pattern (150) on the front face (11) of the substrate (100), the method comprising at least the following steps:
- providing a substrate (100) having a front face (11) surmounted at least by a masking layer (300) comprising carbon atoms,
- defining at least one mask pattern (301) in the masking layer (300) so that the masking layer (300) comprises adjacent regions with different height levels,
- performing an ion implantation of the substrate (100) through said front face (11) and at least upright of the mask pattern (301), so as to form at least one first area (110) modified by implantation and at least one second area (111) not modified by the implantation or less modified than the first area (110), the implantation conditions being chosen so that after implantation the at least one first area (110) has a resistivity p1 less than the resistivity p2 of the at least one second area (111),
- removing the masking layer (300) so that the front face (11) of the substrate (100) is exposed,
**characterised in that** it then comprises at least the following successive steps:
- after the implantation step, immersing the substrate (100) in an electrolyte (4) so that the front face (11) of the exposed substrate (100) is completely in contact with the electrolyte (4),
- removing the at least one first area (110) selectively to the at least one second area (111) so as to form on the front face (11) of the substrate at least one pattern (150) the geometry of which depends on the mask pattern (301), the removal step comprising at least applying an electrochemistry step to the substrate (100) for causing a porosification of the at least one first area (110) selectively to the at least one second area (111), the removal step being carried out so that, at least during the electrochemistry step, at least one rear face (12) of the substrate (100) opposite the front face (11) has charge carriers.
and **characterised in that**
- during the implantation step, the substrate (100) is surmounted by a buffer layer (200) located between the front face (11) of the substrate and the masking layer (300), the buffer layer (200) being shaped so as to trap the carbon atoms which would be torn from the masking layer (300) during said ion implantation.

2. The method according to the preceding claim, wherein the implantation is carried out so that p2 ≥ 1.1*p1, preferably so that p2 ≥ 2*p1 and preferably so that p2 ≥ 3*p1.

3. The method according to any one of the preceding claims, wherein the electrochemistry is carried out so that said porosification of the modified areas (110) causes complete detachment of the at least one first area (110) relative to the at least one second area (111).

4. The method according to any one of claims 1 to 2, wherein the electrochemistry is carried out so that said porosification of the modified areas (110) does not result in complete detachment of the at least one first area (110) relative to the at least one second area (111) and the removal step also comprises, after the electrochemistry step, a step of etching the at least one first area (110) made porous selectively to at least one second area (111).

5. The method according to any one of claims 1 to 2, wherein said ionic implantation of the substrate (100) is carried out so as to form several first areas (110) modified by implantation, and wherein the electrochemistry is carried out so that said porosification of the modified areas (110):
- results in a complete detachment of only some of said several first areas (110) relative to the at least one second area (111),
- does not result in a complete detachment of the other first areas (110) relative to the at least one second area (111) and the removal step also comprises, after the electrochemistry step, a step of etching said other first areas (110).

6. The method according to any one of the preceding claims, wherein the ions implanted during implantation are taken from: ions whose atomic mass is greater than the atomic mass of boron, hydrogen (H) based ions and helium (He) based ions.

7. The method according to any one of the preceding claims, wherein the ionic implantation of the substrate (100) is carried out so that the ions are implanted with an energy less than or equal to 150keV.

8. The method according to any one of the preceding claims, wherein the removal step comprises a selective wet etching of the at least one first area (110) made porous selectively to the at least one second area (111) and which the wet etching is preferably carried out in an alkaline medium, preferably based on one of the following solutions: potassium hydroxide (KOH) or tetramethylammonium hydroxide (TMAH).

9. The method according to any one of the preceding claims, wherein the removal step comprises an illumination of the rear face (12) of the substrate (100) so that the rear face (12) of the substrate has charge carriers during the electrochemistry step, the illumination preferably being performed during the electrochemistry step.

10. The method according to any one of the preceding claims, comprising, before the step of immersing the substrate (100) in the electrolyte, a step of doping the rear face (12) so that the rear face (12) of the substrate has charge carriers during the electrochemistry step.

11. The method according to any one of the preceding claims, wherein the step of defining the at least one mask pattern (301) in the masking layer (300) is carried out such that the masking layer (300) comprises at least one first region having a non-zero height level and at least one second region, adjacent to the first region and having a zero height level, said first and second regions defining in the masking layer (300) at least one two-dimensional mask pattern (301).

12. The method according to any one of the preceding claims, wherein the step of defining the at least one mask pattern (301) in the masking layer (300) is carried out so that the masking layer (300) comprises at least one first region having a first non-zero height level and at least one second region, adjacent to the first region and having a second non-zero height level and different from the first height level, said first and second regions defining in the masking layer (300) at least one three-dimensional mask pattern (301).

13. The method according to any one of the preceding claims, wherein the masking layer (300) is shaped and the ion implantation is carried out so as to form in the substrate (100) at least two adjacent first areas (110) and having different and non-zero implantation depths.

14. The method according to any one of the preceding claims, wherein during the electrochemistry step, a constant intensity of the current passing between an anode (2) formed partially at least by the substrate (100) and a cathode (3) immersed in electrolyte (4) is maintained, the evolution of the voltage between the anode (2) and the cathode (3) is monitored, and when a stabilisation is detected, it is deduced that all of the at least one first area (111) has been made porous.

15. The method according to any one of the preceding claims, configured so that said pattern (150) formed on the front face (11) of the substrate (100) at the end of the removal step has dimensions proportional to those of the mask pattern (301) and preferably configured such that said pattern (150) formed on the front face (11) of the substrate (100) at the end of the removal step is identical to said mask pattern (301).
